(19) Europäisches Patentamt

European Patent Office

Office européen des brevets

(11) EP 0 854 502 A2

(12) EUROPEAN PATENT APPLICATION

(43) Date of publication:
22.07.1998 Bulletin 1998/30

(51) Int. Cl.⁶: **H01L 21/311**, C23F 1/44

(21) Application number: 98100701.6

(22) Date of filing: 16.01.1998

(84) Designated Contracting States:
AT BE CH DE DK ES FI FR GB GR IE IT LI LU MC NL PT SE
Designated Extension States:
AL LT LV MK RO SI

(30) Priority: 21.01.1997 US 35956 P

(71) Applicant:
**Texas Instruments Incorporated**
**Dallas, Texas 75251 (US)**

(72) Inventor: **Misra, Ashutosh**
**Dallas, TX 75243 (US)**

(74) Representative:
**Schwepfinger, Karl-Heinz, Dipl.-Ing.**
**Prinz & Partner,**
**Manzingerweg 7**
**81241 München (DE)**

(54) **Iodofluorocarbon gas for the etching of dielectric layers and the cleaning of process chambers**

(57) The perflurocarbon gases currently used in plasma processing utilized in semiconductor manufacturing, such as $CF_4$, $C_2F_6$, $NF_3$, $SF_6$ and $CHF_3$, have high global warming potentials. Iodofluorocarbon gases, such as $CF_3I$ in particular, have low global warming potentials and additionally are non ozone, depleting. Iodoflurocarbon gases are suitable for plasma processing such as plasma etch and CVD clean.

CF3I FLOW RATE = 105 sccm, PRESSURE = 50 mTorr, P = 1.5kW

Si3N4 ETCH RATE (Å/min) vs OXYGEN/CF3I RATIO

FIG. 7

EP 0 854 502 A2

**Description**

FIELD OF INVENTION

The invention relates generally to the field of semiconductor, and more specifically, to gas chemistries used in plasma processing of semiconductor devices.

BACKGROUND OF THE INVENTION

The ozone depletion potential (ODP) is a measure of the effectiveness of a compound in destroying the ozone layer. This phenomenon is restricted exclusively to the stratosphere.

The Global Warming Potential (GWP) is a measure of the effectiveness of a compound in contributing to global surface temperature increase (the "greenhouse effect"). This phenomenon is related to the troposphere.

The perfluorocarbons (PFCs) currently used in plasma processes in the semiconductor industry, namely $CF_4$, $C_2F_6$, $NF_3$, $SF_6$ and $CHF_3$, have high global warming potentials owing to their high atmospheric lifetimes (tens of thousands of years) and their ability to absorb infrared radiation, resulting in the capture and re-emission of radiation that would otherwise escape into the upper regions of the atmosphere. The United States has developed the Climate Change Action Plan which requires the emission levels of these gases to reach 1990 levels by the year 2000.

Hence there is need to reduce the emission levels, and several strategies to accomplish that are underway. Some of these strategies include abatement, recycle/recovery and process optimization. Finding an alternative chemistry may perhaps be the most logical choice, but at the same time, the most difficult one.

An alternative chemistry is identified in U.S. Patent 4,374,698 issued to Sanders et al. on Feburary 22, 1983. This patent touts $CF_3Br$ as a possible plasma processing gas. This gas, however is unsuitable for longterm use by the semicondctor industry. Report No. 37 entitled "Scientific Assessment of Ozone Depletion: 1994" for World Meteorological Organization Global Ozone Research and Monitoring Project advises that the recommended ODP for $CF_3Br$ is ~ 12, which implies that it is 12 times more effective than CFC-11 (ODP=1.0) in ozone destruction. While $CF_3Br$ has a low global warning potential (GWP), compared to the currently industry used $C_2F_6$, its high ozone depletion potential makes it unsafe for large scale uses based on environmental considerations. Moreover, current international agreements require a complete phaseout of ozone depleting gases by the end of the century, and $CF_3Br$ is on that list. ($CF_3Br$ and other bromocarbons are widely used in fire extinguishing applications).

What is needed is a gas chemistry suitable for plasma processing which is non global warming.

It is accordingly an object of the invention to provide a gas chemistry that is suitable for use in processing semiconductor wafers that is non global warming.

SUMMARY OF INVENTION

$CF_3I$ is a non global warming and non ozone depleting iodofluocarbon gas that can be used in various plasma applications, such as plasma etch and CVD clean, which are used in semiconductor manufacturing.

BRIEF DESCRIPTION OF DRAWINGS

The present invention will now be further described by way of example, with reference to the accompanying drawings in which:

FIG. 1 illustrates a flow rate calibration factor for $CF_3I$.

FIG. 2 illustrates a silicon oxide ($SiO_2$) etch rate dependence as RF power varies.

FIG. 3 illustrates a silicon nitride ($Si_3N_4$) etch rate dependence as RF power varies.

FIG. 4 illustrates a silicon oxide etch rate dependence as flow rate of $CF_3I$ varies.

FIG. 5 illustrates a silicon nitride etch rate dependence as flow rate of $CF_3I$ varies.

FIG. 6 illustrates a silicon oxide etch rate dependence as gas composition varies with added oxygen.

FIG. 7 illustrates a silicon nitride etch rate dependence as gas composition varies with added oxygen..

FIG. 8 shows a silicon oxide etch rate dependence on the flow rate of a 50:50 mixture of $C_2F_6$ and $O_2$.

FIG. 9 depicts a silicon nitride etch rate dependence on the flow rate of a 50:50 mixture of $C_2F_6$ and $O_2$.

DETAILED DESCRIPTION OF PREFERRED EMBODIMENT

Two of the major uses of perfluorocarbons like $CF_4$, $C_2F_6$, $NF_3$, etc., in the semiconductor industry include (a) Chemical Vapor Deposition (CVD) chamber cleaning and (2) Semiconductor wafer patterning. Since these applications typically take place in a reaction chamber under a plasma potential, these applications will be referred to as "plasma applications" herein. Requirements are more stringent for wafer patterning applications, since issues like selectivity and anisotropy have to be kept in consideration. CVD chamber cleaning however has less strict requirements, the major requirement being the ability of gases to etch dielectric films (which are left behind in the chamber during the CVD process). A very large fraction of perfluorocarbons, up to 85%, is currently used in CVD chamber cleaning applications, and hence it is desirable to find an alternative chemistry for such applications. It should be noted that the chemistry which works in CVD chamber cleaning sequence has a very strong potential for being suitable in wafer patterning applications, since the primary step, which is etching of dielectric films, is common to both.

With the above in mind, $CF_3I$ and other iodofluoro-carbons, are suitable alternatives. Experiments, as described below, establish that $CF_3I$ can be efficiently used in CVD chamber cleaning applications, and can be used in wafer patterning applications. The experiements demonstrate the feasibility of using a non-global warming gas like $CF_3I$ (the first member in the family of iodofluorocarbons) in CVD chamber cleaning applications. $CF_3I$ successfully etches silicon oxide and silicon nitride films (the dielectric films most commonly used in CVD applications) and is a suitable alternative for undesirable global-warming gasses like $C_2F_6$.

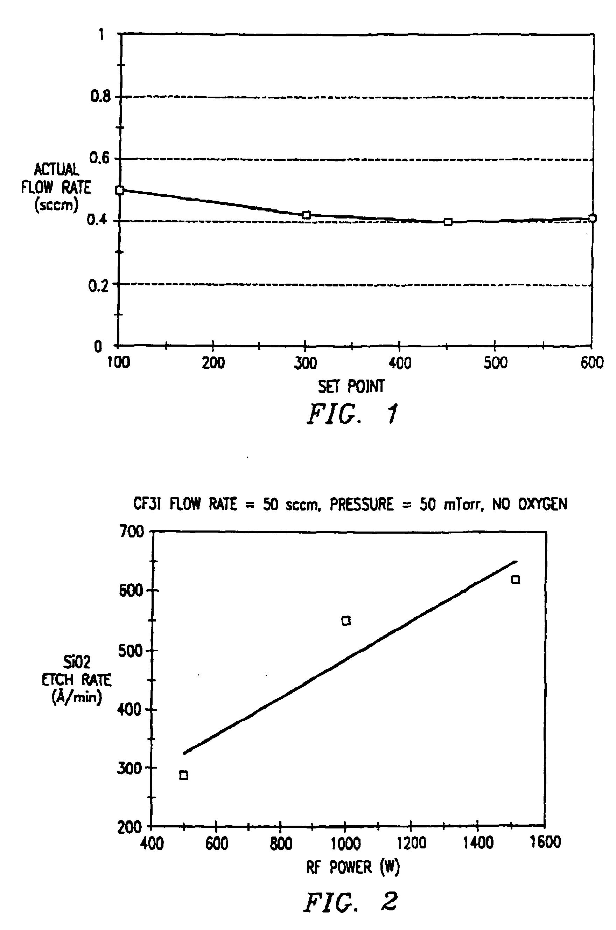

Experiments were carried out on a commercially available Applied Materials 3300 IIA parallel plate enhanced Chemical Vapor Deposition (CVD) plasma batch reactor. Plasma oxide and nitride films were deposited on silicon wafers and the wafers were then subjected to a plasma of $CF_3I$. The effect of relevant process parameters on the etch rate of plasma deposited silicon oxide and silicon nitride films on silicon wafers were investigated. The term "etch rate" is defined as the rate at which the films are etched when exposed to an etching environment (a gas plasma in this study): the etch rate is calculated by measuring the film thickness (using a device such as a Nanospec) before and after exposure to the gas plasma and noting the time for which the film was exposed to the plasma. The etch rate is expressed in units of angstroms/minute ($Å/min$). The units of gas flow rate are "standard cubic centimeters per minute" (sccm); units of pressure are "millitorr" (mTorr); units of radio frequency (RF) power are "Watts" (W) or "kilowatts" (kW, where 1 kW = 1000 W). The flow rate of $CF_3I$ was monitored using an MKS flow controller calibrated for $N_2$ flows and a flow rate calibration factor for $CF_3I$ was determined in the flow range of 50 to 250 sccm. FIG. 1 illustrates the flow rate calibration factor for $CF_3I$.

FIG. 2 illustrates the silicon oxide ($SiO_2$) etch rate dependence as RF power varies. The flow rate of $CF_3I$ was 50 sccm and the pressure was 50 mTorr. No oxygen was added.

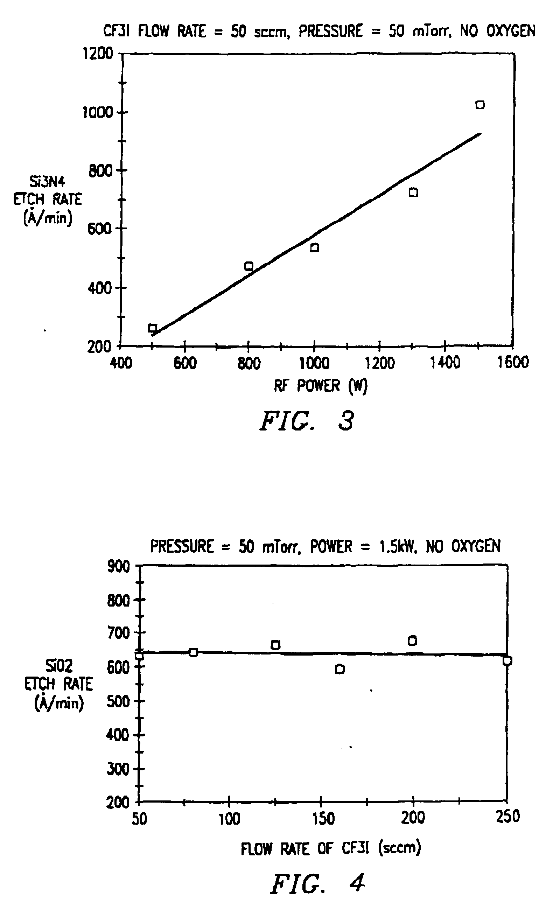

FIG. 3 illustrates the silicon nitride ($Si_3N_4$) etch rate dependence as RF power varies. The flow rate of $CF_3I$ was 50 sccm and the pressure was 50mTorr. No oxygen was added.

FIG. 4 illustrates the silicon oxide etch rate dependence as flow rate of $CF_3I$ varies. The pressure was 50 mTorr and the power was 1.5kW. No oxygen was added.

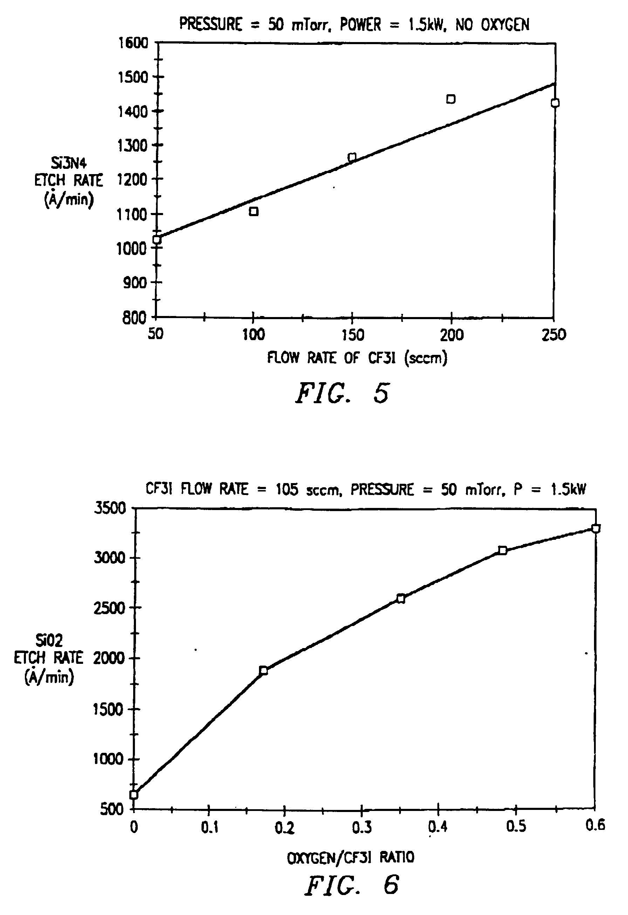

FIG. 5 illustrates the silicon nitride etch rate dependence as flow rate of $CF_3I$ varies. The pressure was 50 mTorr and the power was 1.5kW. No oxygen was added.

Further experiments were conducted with the above described reactor to determine if $CF_3I$ could etch silicon oxide and silicon nitride at the same rate as currently used $C_2F_6$ + $O_2$ mixtures.

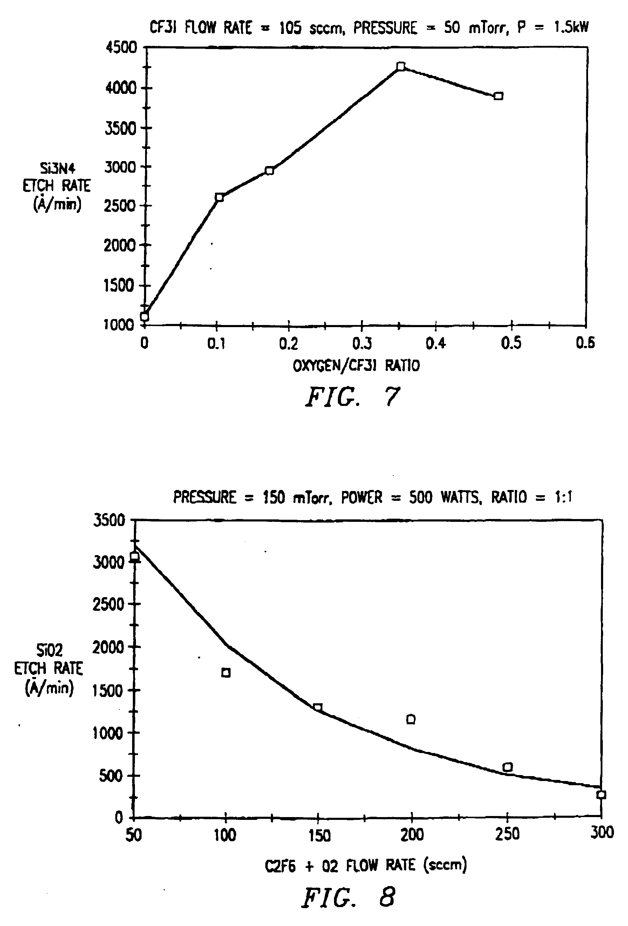

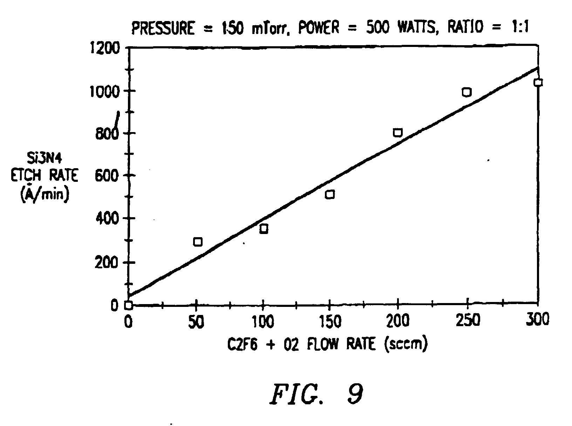

For $C_2F_6$ + $O_2$ mixtures, under optimized conditions of flow rate = 50 sccm, pressure = 150 mTorr, power = 500 Watts, the etch rate of silicon oxide films was observed to be in excess of 3000 Å/min and silicon nitride etch rate was about 1200 Å/min. FIG. 8 shows the silicon oxide etch rate dependence on the flow rate of a 50:50 mixture of $C_2F_6$ and $O_2$. FIG. 9 depicts the silicon nitride etch rate dependence on the flow rate of a 50:50 mixture of $C_2F_6$ and $O_2$.

As shown in FIG. 4, without any added oxygen, the iodofluorocarbon $CF_3I$ was observed to etch silicon oxide films at a rate of 650 Å/min. It was then decided to add oxygen flow to the $CF_3I$ flow to enhance the etch rate and also to prevent polymer formation which is a characteristic event in such plasmas. FIG. 6 illustrates the silicon oxide etch rate dependence as gas composition varies. The $CF_3I$ flow rate was 105 sccm, the pressure was 50 mTorr and the power was 1.5 kW. Oxygen was added to vary the oxygen/$CF_3I$ ratio. It was observed that the etch rate of silicon oxide ($SiO_2$) increases with oxygen content up to 60%, reaching values in excess of 3000 Å/min., thus establishing the feasibility of using $CF_3I/O_2$ mixtures as a substitute for $C_2F_6/O_2$ mixtures.

A similar study was also carried out to investigate the etch rate of silicon nitride ($Si_3N_4$) in a $CF_3I/O_2$ plasma. FIG. 7 illustrates the silicon nitride etch rate dependence as gas composition varies. The $CF_3I$ flow rate was 105 sccm, the pressure was 50 mTorr and the power was 1.5 kW. Oxygen was added to vary the oxygen/$CF_3I$ ratio.Maximum etch rate of silicon nitride was observed when the oxygen/$CF_3I$ ratio was around 0.40.

From the above described experiments, it appears that an optimal set of operating conditions for the CVD reactor used in the experiments include a mixture of $CF_3I/O_2$ and the following reactor parameters

Pressure = 50 mTorr
R.F. Power = 1.5 kWatts
Flow rate of $CF_3I$ = 105 sccm
Oxygen/$CF_3I$ ratio = 0.6 for etching $SiO_2$ films
0.4 for etching $Si_3N_4$ films

It should be noted, however, that the above conditions are specific to the CVD chamber used in this study. It is known to those familiar with the art that the plasma operating conditions are heavily dependent upon the specific CVD chamber in use. The above mentioned conditions provide a good starting point for optimizing the process; the actual optimum process parameters such as flow rate, RF power and pressure will vary from one system to another. It is anticipated that the following range of operating conditions would cover various configurations:

Pressure = 50 mTorr - 10 Torr
R. F. Power = 500 Watts - 2000 Watts
Flow rate of $CF_3I$ = 100 sccm - 1000 sccm

Oxygen/$CF_3I$ ratio = 0.3 - 0.7

The $CF_3I$ gas mixture is more environmentally friendly than $CF_3Br$. Carbon-Iodine bonds are weaker than carbon-bromine bonds, and thus the iodofluorocarbons (IFCs) are less stable (and hence more reactive) than the corresponding bromine analogues. The C-Br bond strength in $CF_3Br$ is 63 kcal/mol.. The C-I bond strength in $CF_3I$ is 54 kcal/mol, which makes $CF_3I$ more photochemically reactive than $CF_3Br$. the lifetime of $CF_3I$ in the sunlit atmosphere is less than one day compared to a lifetime of 65 years for $CF_3Br$. The fraction of $CF_3I$ reaching the stratosphere will be negligible, around $10^{-53}$, based on calculations, and thus it will pose no threat to the ozone layer. The calculated ozone depletion potential for $CF_3I$ is 0.008, that is, it is 12/0.008 = 1500 times less of a danger to the ozone layer, compared to $CF_3Br$. It is very likely that the ODP of $CF_3I$ is 0.0001, which makes it even more environmentally safe. The GWP of $CF_3I$ is very small, less than 5, on a 20 year timescale compared with the GWP of $CF_3Br$ which is 6200. The acute toxicity of $CF_3I$ is very low as well.

The reasoning for almost zero ODP and GWP of $CF_3I$ can be extended to other iodofluorocarbons (IFCs); they are predicted to have similar numbers. $CF_3I$ is the first member of the family of iodofluorocarbons- other members for instance will be $C_2F_5I$, $C_3F_7I$.. etc. These iodofluorocarbons will also etch dielectric films in the same manner as $CF_3I$ because the anticipated fragmentation patterns for various iodofluorocarbons in a plasma would be very similar, such as shown below in Equation (1) through Equation (7):

$$CF_3I \rightarrow CF_3 + I \qquad (1)$$

$$CF_3 \rightarrow CF_2 + F \qquad (2)$$

$$C_2F_5I \rightarrow C_2F_5 + I \qquad (3)$$

$$C_2F_5 \rightarrow CF_3 + CF_2 \qquad (4)$$

$$C_3F_7I \rightarrow C_3F_7 + I \qquad (5)$$

$$C_3F_7 \rightarrow C_2F_5 + CF_2 \qquad (6)$$

$$O_2 \rightarrow O + O \qquad (7)$$

$CF_3$ and $CF_2$ radicals (referred to as $CF_x$ in equation (8)) are primarily responsible for etching dielectric films by mechanisms such as the one shown below

$$SiO_2 + CF_x \rightarrow SiF_x + CO_2 \qquad (8)$$

The transient species generated in reactions (1) through (7) can undergo further reactions, leading to the formation of stable by products, which will emerge from the plasma chamber in the effluent stream. Reactions (9) through (19) below show possible pathways for the formation of some of these by-products. It will be well known to those in the art that the reactions shown below merely serve as a guideline for prediction of by-products: a thorough effluent stream analysis is necessary to characterize the stable species emerging from a plasma chamber. The term "plasma chamber" here refers to a process chamber which employs a radio frequency or microwave plasma to assist chemical reactions which are of interest in semiconductor processing- examples of plasma chambers include, but are not limited to chemical vapor deposition (CVD) chambers and plasma etch tools employed for wafer patterning.

$$CF_3I + O \rightarrow IO + CF_3 \qquad (9)$$

$$2 CF_3 \rightarrow C_2F_6 \qquad (10)$$

$$CF_3 + O_2 \rightarrow CF_3O + O \qquad (11)$$

$$CF_3O \rightarrow CF_2O + F \qquad (12)$$

$$I + F \rightarrow IF \qquad (13)$$

$$IF + F \rightarrow IF_2 \qquad (14)$$

$$IF_2 + F \rightarrow IF_3 \qquad (15)$$

$$IF_3 + F \rightarrow IF_4 \qquad (16)$$

$$IF_4 + F \rightarrow IF_5 \qquad (17)$$

$$IF_3 + IF_2 \rightarrow IF_5 + I \qquad (18)$$

$$IF_2 + IF_2 \rightarrow IF_4 + I \qquad (19)$$

While the invention has been described with reference to illustrative embodiments, this description is not intended to be construed in a limiting sense. Various other embodiments of the invention will be apparent to persons skilled in the art upon reference to this description. Other dielectric films can also be etched using the recipe proposed in this invention; these films include, but are not limited to TEOS (TetraEthylOrthoSilicate) and Oxynitride films.

## Claims

1. A method of cleaning a semiconductor reactor chamber, comprising the steps of:

   forming a plasma in said reactor chamber; and introducing an iodoflurocarbon gas into the reactor chamber to remove deposits from walls of the reactor.

2. The method of Claim 1, wherein the deposits are silicon oxide.

3. The method of Claim 1 or Claim 2, wherein the deposits are silicon nitride.

4. The method of any preceding claim, wherein the iodoflurocarbon gas comprises $CF_3I$.

5. A method of etching a dielectric film, comprising the steps of:

   introducing a semiconductor wafer having said dielectric film formed on a surface thereof into a reactor chamber;
   forming a plasma in the reactor chamber; and introducing an iodoflurocarbon gas into the reactor chamber to etch the dielectric film.

6. The method of Claim 5, wherein the dielectric film comprises silicon oxide.

7. The method of Claim 5 or Claim 6, wherein the dielectric film comprises silicon nitride.

8. The method of any of Claims 5 to 7, wherein the iodoflurocarbon gas comprises $CF_3I$.

FIG. 1

CF3I FLOW RATE = 50 sccm, PRESSURE = 50 mTorr, NO OXYGEN

FIG. 2

CF3I FLOW RATE = 50 sccm, PRESSURE = 50 mTorr, NO OXYGEN

FIG. 3

PRESSURE = 50 mTorr, POWER = 1.5kW, NO OXYGEN

FIG. 4

PRESSURE = 50 mTorr, POWER = 1.5kW, NO OXYGEN

*FIG. 5*

CF3I FLOW RATE = 105 sccm, PRESSURE = 50 mTorr, P = 1.5kW

*FIG. 6*

CF3I FLOW RATE = 105 sccm, PRESSURE = 50 mTorr, P = 1.5kW

FIG. 7

PRESSURE = 150 mTorr, POWER = 500 WATTS, RATIO = 1:1

FIG. 8

PRESSURE = 150 mTorr, POWER = 500 WATTS, RATIO = 1:1

*FIG. 9*